# EUROPÄISCHE PATENTSCHRIFT

(11) **EP 1 644 778 B1**
(45) Veröffentlichungstag und Bekanntmachung des Hinweises auf die Patenterteilung: **14.03.2007**
(21) Anmeldenummer: 04732122.9
(22) Anmeldetag: 11.05.2004
(51) Int. Cl.: G03F 7/20

(54) **VERFAHREN ZUR BEWERTUNG VON AUFGENOMMENEN BILDERN VON WAFERN**
METHOD FOR EVALUATING RECORDED IMAGES OF WAFERS
PROCEDE D'EVALUATION D'IMAGES DE PLAQUETTES ENREGISTREES

(30) Priorität: 14.07.2003 DE 10331686
(43) Veröffentlichungstag der Anmeldung: 12.04.2006
(73) Patentinhaber: Vistec Semiconductor Systems GmbH, 35781 Weilburg (DE)
(72) Erfinder: MICHELSSON, Detlef, 35584 Wetzlar-Naunheim (DE)
(74) Vertreter: Reichert, Werner Franz
(86) Internationale Anmeldenummer: PCT/EP2004/050758
(87) Internationale Veröffentlichungsnummer: WO 2005/006080

(56) Entgegenhaltungen:
- US-A- 4 527 070
- US-A- 4 600 597
- US-A- 5 544 256
- US-A- 6 047 083
- US-A- 6 148 099
- US-A1- 2001 036 306
- US-B1- 6 477 265
- US-B1- 6 541 283

## Beschreibung

Die Erfindung betrifft ein Verfahren zur Bewertung von aufgenommenen Bildern von Wafern.

In der Halbleiterfertigung werden Wafer während des Fertigungsprozesses in einer Vielzahl von Prozessschritten sequentiell bearbeitet. Mit zunehmender Integrationsdichte steigen die Anforderungen an die Qualität der auf den Wafern ausgebildeten Strukturen. Um die Qualität der ausgebildeten Strukturen überprüfen und eventuelle Defekte finden zu können, ist das Erfordernis an die Qualität, die Genauigkeit und die Reproduzierbarkeit der den Wafer handhabenden Bauteile und Prozessschritte entsprechend. Dies bedeutet, dass bei der Produktion eines Wafer mit der Vielzahl von Prozessschritten und der Vielzahl der aufzutragenden Schichten an Photolack oder Ähnlichem eine zuverlässige und frühzeitige Erkennung von Defekten besonders wichtig ist. Bei der optischen Erkennung von Fehlern gilt es dabei die systematischen Fehler durch die Dickenschwankungen bei der Belackung der Halbleiterwafer zu berücksichtigen, um somit einer Markierung von Stellen auf dem Halbleiterwafer zu vermeiden, die keinen Fehler beinhalten.

Makroskopische Bilder von Halbleiterwafern zeigen, dass die Homogenität der Schichten oder Layer sich radial ändert. Insbesondere bei der Belackung treten in den vom Mittelpunkt des Wafers entfernten Bereichen veränderte Homogenitäten auf. Wird wie bisher eine einheitliche Empfindlichkeit über den gesamten Radius des Wafers für die Bewertung von Bildern der aufgenommenen Wafer verwendet, so kommt es vor, dass die Abweichungen am Rand immer, jedoch Defekte im Inneren (nahe am Mittelpunkt des Wafers) nicht detektiert werden. Wird eine hohe Empfindlichkeit gewählt, um Defekte in homogenen Gebieten sicher zu detektieren, so treten in den Randbereichen verstärkte Fehldetektionen auf, da die inhomogenen Randbereiche nicht immer als Fehler zu bewerten sind. Um dies zu verhindern, kann man die Randbereiche komplett ausklammern. Jedoch werden dann dort keine echten Fehler gefunden. Wählt man dagegen eine geringere Empfindlichkeit so kommt es zwar zu keinen Fehldetektionen mehr, jedoch können Fehler in den homogenen Gebieten nicht gefunden werden.

Der Erfindung liegt die Aufgabe zugrunde ein Verfahren zu schaffen, mit dem unter Berücksichtigung der Inhomogenitäten auf der Oberfläche eines Wafers eine eindeutige Detektion von Fehlern möglich ist.

Diese Aufgabe wird durch ein Verfahren mit den Merkmalen des Anspruchs 1 gelöst.

Es ist von besonderen Vorteil, wenn zuerst ein Bild mindestens eines Referenzwafers aufgenommen wird. An Hand der Aufnahme erfolgt ein Ermitteln und Darstellen der radialen Verteilung der Messwerte des Referenzwafers als eine radiale Homogenitätsfunktion auf einem Userinterface. Ein radial abhängiges Empfindlichkeitsprofils wird unter Berücksichtigung der radialen Homogenitätsfunktion des Referenzwafers verändert, wobei mindestens ein Parameter des Empfindlichkeitsprofils variiert wird, wodurch ein erlerntes Empfindlichkeitsprofil visuell aus dem Vergleich mit der radialen Homogenitätsfunktion bestimmt wird. Ermittelt werden Fehler auf mindestens einem weiteren Wafer an Hand des Vergleichs des erlernten radialen Emplindlichkeitsprofils des Referenzwafers und der gemessenen radialen Verteilung der Homogenitätsfunktion des mindestens einen weiteren Wafers. Der Fehler auf dem Wafer ist durch das Unterschreiten des erlernten Empfindlichkeitsprofils durch die gemessene radialen Verteilung der Homogenitätsfunktion bestimmt. Der gefundene Fehler wird auf einer bildlichen Darstellung des mindestens einen weiteren Wafers markiert.

Das erlernte Empfindlichkeitsprofil ist vom Abstand zu einem Mittelpunkt des Wafers abhängig. Diese Abhängigkeit resultiert aus der Abhängigkeit, die sich aus den Produktionsprozessen der Wafer selbst ergibt. Auf den Wafer werden für nachfolgende lithographische Prozesse Schichten mit einem Spinverfahren aufgetragen. Alleine hieraus resultieren Dickenschwankungen der Schicht oder der Schichten, die bei der Detektion von Fehlern zu berücksichtigen ist.

Es sind mehrere verschiedene Profilformen auf dem Userinterface vorhanden, die zum Bestimmen des erlernten Empfindlichkeitsprofil vom Benutzer ausgewählt werden können.

Besonders geeignet haben sich drei verschiedene Profilformen erwiesen, die zum Bestimmen des erlernten Empfindlichkeitsprofil vom Benutzer ausgewählt werden können. Dabei ist eine erste Profilform unabhängig von der radialen Position auf dem Wafer. Eine zweite Profilform besteht aus einem ersten und einen zweiten Abschnitt, von denen mindestens einer in der Steigung verändert werden kann. Eine dritte Profilform ist vorgesehen, die einen ersten, einen zweiten und einen dritten Abschnitt aufweist, wobei jeder Abschnitt unabhängig im Niveau verändert werden kann.

Mindestens ein Parameter ist veränderbar, um das Empfindlichkeitsprofil an radiale Homogenitätsfunktion eines Wafers anzugleichen. Dabei steht mindestens ein Parameter für die radiale Position eines Übergangs zwischen zwei Abschnitten des Empfindlichkeitsprofils, die sich in der Steigung unterscheiden. Ein weiterer Parameter definiert das Niveau des Empfindlichkeitsprofils, wobei mindestens drei Niveaus des Empfindlichkeitsprofils einstellbar sind. Das Niveau des Empfindlichkeitsprofils ist dabei auf das Niveau der radialen Homogenitätsfunktion bezogen. Die Einstellung des Niveaus bzw. der Abschnitte mit den unterschiedlichen Steigungen kann durch jeweils einen Slider verändert werden.

In der Zeichnung ist der Erfindungsgegenstand schematisch dargestellt und wird anhand der Figuren nachfolgend beschrieben. Dabei zeigen:
Fig. 1 eine schematische Darstellung eines Systems zur Detektion von Fehlern auf Wafern;
Fig. 2a eine Darstellung der Art der Aufnahme der Bilder oder Bilddaten eines Wafers;
Fig. 2b eine schematische Draufsicht auf einen Wafer;
Fig.3 eine Ausführungsform eines Userinterfaces für die Parametereingabe zum Festlegen eines Empfindlichkeitsprofils für die Farbschwankungen auf der Oberfläche eines Wafers; und
Fig. 4 eine Ausführungsform eines Userinterfaces für die Parametereingabe zum Festlegen eines Empfindlichkeitsprofils für die radiale Abeichung der Daten von einem Histogramm.

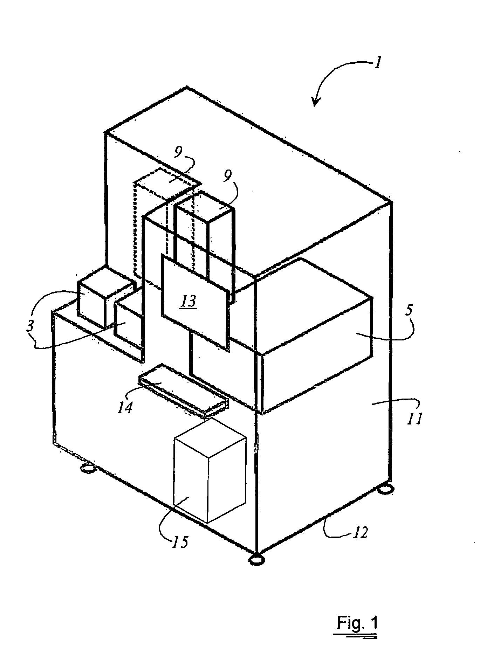

Fig. 1 zeigt ein System 1 zur Detektion von Fehlern auf Wafern. Das System 1 besteht z.B. aus mindestens einem Kassettenelement 3 für die Halbleitersubstrate bzw. Wafer. In einer Messeinheit 5 werden Bilder bzw. Bilddaten von den einzelnen Wafern aufgenommen. Zwischen dem Kassettenelement 3 für die Halbleitersubstrate bzw. Wafer und der Messeinheit 5 ist ein Transportmechanismus 9 vorgesehen. Das System 1 ist von einem Gehäuse 11 umschlossen ist, wobei das Gehäuse 11 eine Grundfläche 12 definiert. Im System 1 ist ferner ein Computer 15 integriert, der die Bilder bzw. Bilddaten von den einzelnen gemessenen Wafern aufnimmt und verarbeitetet. Das System 1 ist mit einem Display 13 und einer Tastatur 14 versehen. Mittels der Tastatur 14 kann der Benutzer Daten eingaben zur Steuerung des Systems oder auch Parametereingaben zur Auswertung des Bilddaten von den einzelnen Wafern machen. Auf dem Display 13 werden dem Benutzer des Systems mehrere Benutzerinterfaces dargestellt.

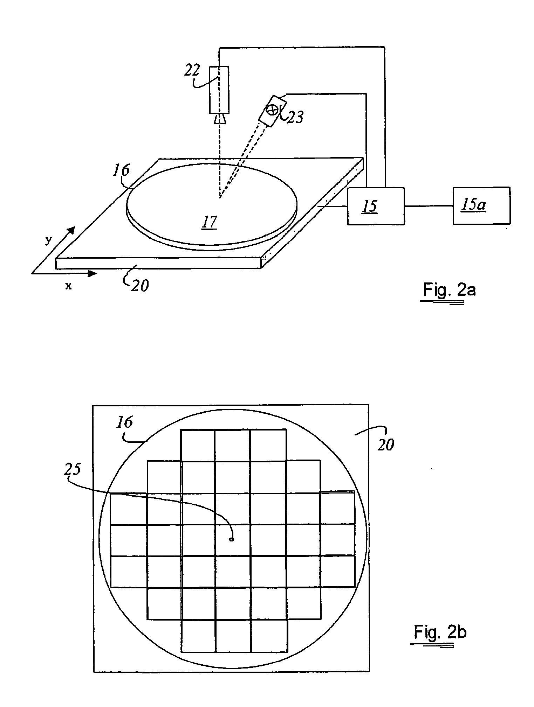

Fig. 2a zeigt eine schematisch Ansicht der Art und Weise, wie von einem Wafer 16 die Bilder und/oder Bilddaten erfasst werden. Der Wafer 16 ist auf einer Tisch 20 aufgelegt, der im Gehäuse 11 in einer ersten Richtung X und einer zweiten Richtung Y verfahrbar ist. Die erste und die zweite Richtung X, Y sind senkrecht zueinander angeordnet. Über der Oberfläche 17 des Wafers 16 ist eine Bildaufnahmeeinrichtung 22 vorgesehen, wobei das Bildfeld der Bildaufnahmeeinrichtung 22 kleiner ist als die gesamte Oberfläche 17 des Wafers 16. Um die gesamte Oberfläche 17 des Wafers 16 mit der Bildaufnahmeeinrichtung 22 zu erfassen, wird der Wafer 16 meanderförmig abgescannt. Die einzelnen nacheinander erfassten Bildfelder werden zu einem gesamten Bild der Oberfläche 17 eines Wafers 16 zusammengesetzt. Die geschieht ebenfalls mit dem in Gehäuse 11 vorgesehenen Computer 15. Um eine Relativbewegung zwischen dem Tisch 20 und der Bildaufnahmeeinrichtung 22 zu erzeugen, wird in diesem Ausführungsbeispiel ein x-y-Scanningtisch verwendet, der in den Koordinatenrichtungen x und y verfahrenen werden kann. Die Kamera 23 ist hierbei gegenüber dem Tisch 20 fest installiert. Selbstverständlich kann auch umgekehrt der Tisch 2 fest installiert sein und die Bildaufnahmeeinrichtung 22 für die Bildaufnahmen über den Wafer 16 bewegt werden. Auch eine Kombination der Bewegung der Kamera 23 in eine Richtung und des Tisches 20 in der dazu senkrechten Richtung ist möglich.

Der Wafer 16 wird mit einer Beleuchtungseinrichtung 23 beleuchtet, die zumindest Bereiche auf dem Wafer 16 beleuchtet, die dem Bildfeld der Bildaufnahmeeinrichtung 22 entsprechen. Durch die konzentrierte Beleuchtung, die zudem auch mit einer Blitzlampe gepulst sein kann, sind Bildaufnahmen on-the-fly möglich, bei denen also der Tisch 20 oder die Bildaufnahmeeinrichtung 22 ohne für die Bildaufnahme anzuhalten verfahren werden. Dadurch ist ein großer Waferdurchsatz möglich. Natürlich kann auch für jede Bildaufnahme die Relativbewegung zwischen Tisch 20 und Bildaufnahmeeinrichtung 22 angehalten werden und der Wafer 16 auch in seiner gesamten Oberfläche 17 beleuchtet werden. Der Tisch 20, Bildaufnahmeeinrichtung 22 und Beleuchtungseinrichtung 23 werden vom Computer 15 gesteuert. Die Bildaufnahmen können durch den Computer 15 in einem Speicher 15a abgespeichert und gegebenenfalls auch von dort wieder aufgerufen werden.

Fig. 2b zeigt die Draufsicht auf einen Wafer 16, der auf einen Tisch 20 aufgelegt ist. Der Wafer 16 besitzt einen Mittelpunkt 25. Auf dem Wafer 16 werden Schichten aufgetragen, die dann in einem weiteren Arbeitsgang strukturiert werden. Ein strukturierter Wafer umfasst eine Vielzahl von strukturierten Elementen.

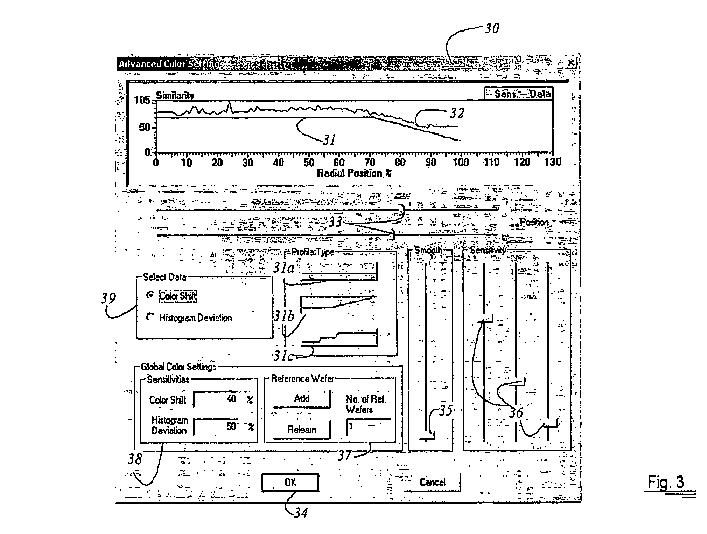

Fig. 3 zeigt eine Ausführungsform eines Userinterfaces 30 für die Parametereingabe zum Festlegen eines Empfindlichkeitsprofils 31 für die Farbschwankungen auf der Oberfläche 17 eines Wafers 16. Auf dem Userinterface 30 ist die Farbschwankung als eine Funktion 32 des Radius des Wafers 16 aufgetragen. Die Abweichungen werden bewertet und die Schwankungen der Funktion 32 ist ein Maß für die Änderung der Farbe der Oberfläche 17 des Wafers 16 vom Mittelpunkt 25 des Wafers 16 aus gesehen. Die Funktion 32 bzw. Kurve ergibt sich aus dem Minimum aller auf einem Abstand zum Mittelpunkt 25 bzw. aller auf einem Radius liegenden Messwerte. Zur Anpassung eines Empfindlichkeitsprofils 31 an die Funktion 32 stehen dem Benutzer mehrere verschiedene Profilformen 31a, 31b und 31c zur Verfügung, um somit ein erlerntes Empfindlichkeitsprofil 31 zu bestimmen und festzulegen. Das so bestimmte Empfindlichkeitsprofil 31 wird für Bestimmung und Kennzeichnung der Fehler auf anderen Wafers eines Loses verwendet. In der Produktion bzw. in der Anwendung des eingelernten Empfindlichkeitsprofil 21 wird dieses mit den Messwerten der verschiedenen Wafer eines Loses verglichen. Ein Fehler wird dann charakterisiert, wenn ein Messwert das erlernte Empfindlichkeitsprofil 31 unterschreitet. Das in Fig. 3 dargestellte Userinterface 30 wird auf dem Display 15 dargestellt und der Benutzer kann über die Tastatur 14 die erforderlichen Eingaben machen. Nachdem der Benutzer eine erste, eine zweite oder eine dritte Profilform 31a, 31b oder 31c ausgewählt hat, kann er diese im visuellen Vergleich zu der Funktion 32 ändern. Die Veränderung eines radial abhängigen Empfindlichkeitsprofils 31 unter Berücksichtigung der radialen Funktion 32 des Referenzwafers erfolgt derart, dass mindestens ein Parameter der ausgewählten Profilform variiert wird, wodurch ein erlerntes Empfindlichkeitsprofil visuell bestimmt wird. Der Benutzer kann also auf dem Display visuell abschätzen, ob er mit der Anpassung des Empfindlichkeitsprofils 31 an die jeweils aktuelle Funktion zufrieden ist. Auf dem Userinterface 30 werden dem Benutzer Positionierelemente 33 dargestellt. Die Darstellung der Positionierelemente 33 ist unter der graphischen Darstellung der Empfindlichkeitsprofis 31 und der Funktion 32 angebracht. Die Lage der Positionierelemente 33 kann z.B. über eine Maus (nicht dargestellt) verändert werden. Die zweite und die dritte Profilform 31b und 31c besitzen können mindestens einen Abschnitt aufweisen, der eine andere Steigung besitzt als der Rest der Profilform. In der in Fig. 3 dargestellten Ausführungsform sind zwei Abschnitte in der Profilform 31 vorgesehen, die sich in ihrer Steigung unterscheiden. Der Übergang von einem Abschnitt zum anderen wird in Fig. 3 durch eines der Positionierelemente 33 festgelegt. Auf dem Display 30 werden dem Benutzer ein Einstellelement 35 für die Glättung des Empfindlichkeitsprofis 31 bereitgestellt. Hinzu kommt, dass weitere Einstellelemente 36 für die Empfindlichkeit des Empfindlichkeitsprofis 31 dem Benutzer dargeboten werden. Mit der Vielzahl an Einstellelementen 33, 35 und 36 kann der Benutzer das Empfindiichkeitsprofis 31 an die Funktion 32 angleichen und die erfolgten Änderungen auf dem Display 13 zu beobachten und hinsichtlich ihrer Relevanz abschätzen. Das Userinterface 30 stellt den Benutzer ebenfalls noch eine Auswahlfeld zur 37 Verfügung, mit dem er Empfindlichkeitsprofile von weiteren Referenzwafern zu den bestehenden eingelernten Empfindlichkeitsprofilen hinzufügen will. Ferner hat der Benutzer die Möglichkeit einen neuen Wafer als Referenzwafer zu verwenden und für diesen ein neues eingelerntes Empfindlichkeitsprofil zu erstellen. In einem Eingabefeld 38 erhält der Benutzer die Information über die allgemeinen Einstellungen hinsichtlich der Farbänderungen bei einem Wafer. Die Einstellungen umfassen die Farbverschiebung und die Abweichung von einem Histogramm. In einem Auswahlfeld 39 wird dem Benutzer angezeigt welche Datenauswahl getroffen oder eingestellt worden ist. In dem in Fig. 3 dargestellten Ausführungsbeispiel ist die Farbverschiebung ausgewählt. Mit einem OK-Button 34 bestätigt der Benutzer seine Eingaben bzw. Einstellungen.

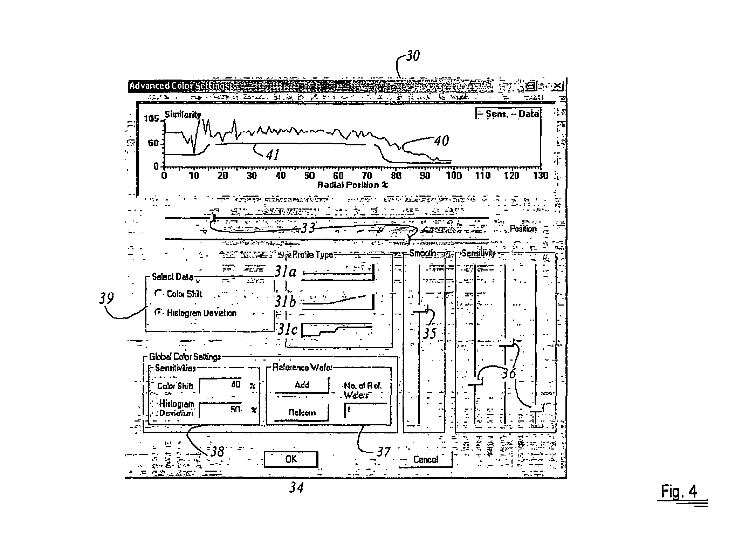

Fig. 4 zeigt eine Ausführungsform eines Userinterfaces für die Parametereingabe zum Festlegen eines eingelernten Empfindlichkeitsprofils, wobei als Funktion 40 die radiale Abeichung der Daten vom Histogramm dargestellt sind. Die Darstellung des Userinterfaces aus Fig. 4 ist mit der Darstellung aus Fig. 3 vergleichbar. Es wurden gleiche Bezugszeichen für gleiche Komponenten verwendet. Für die Anpassung eines Empfindlichkeitsprofils 41 an die radiale Funktion 40 ist eine Profilform 31 ausgewählt, die drei Abschnitte aufweist, die in der Steigung und/oder dem Niveau unterscheiden. Display visuell abschätzen, ob er mit der Anpassung des Empfindlichkeitsprofils 31 an die jeweils aktuelle Funktion zufrieden ist. Die auf dem Userinterface 30 dargestellten Positionierelemente 33 können vom Benutzer derart verschoben werden, dass sie die Lage der der Übergänge zwischen den einzelnen Abschnitten markieren. Die Darstellung der Positionierelemente 33 ist unter der graphischen Darstellung der Empfindlichkeitsprofis 41 und der Funktion 40 angebracht. Hinzu kommt, dass weitere Einstellelemente 36 für die Empfindlichkeit des Empfindlichkeitsprofis 31 dem Benutzer dargeboten werden. Mit der Vielzahl an Einstellelementen 33, 35 und 36 kann der Benutzer das Empfindlichkeitsprofis 31 an die Funktion 32 angleichen und die erfolgten Änderungen auf dem Display 13 zu beobachten und hinsichtlich ihrer Relevanz abschätzen.

## Patentansprüche

1. Verfahren zur Bewertung von aufgenommenen Bildern von Wafern **gekennzeichnet durch** die folgenden Schritte:
- Aufnehmen des Bildes mindestens eines Referenzwafers,
- Ermitteln und Darstellen der radialen Verteilung der Messwerte des Referenzwafers als eine radiale Homogenitätsfunktion auf einem Userinterface, und
- Verändern eines radial abhängigen Empfindlichkeitsprofils unter Berücksichtigung der radialen Homogenitätsfunktion des Referenzwafers, wobei mindestens ein Parameter des Empfindlichkeitsprofils variiert wird, wodurch ein erlerntes Empfindlichkeitsprofil visuell aus dem Vergleich mit der radialen Homogenitätsfunktion bestimmt wird.

2. Verfahren nach Anspruch 1, **dadurch gekennzeichnet, dass** das Ermitteln von Fehlern auf mindestens einem weiteren Wafer an Hand des Vergleichs des erlernten radialen Empfindtichkeitsprofils des mindestens einen Referenzwafers mit der gemessenen radialen Verteilung der Homogenitätsfunktion des mindestens einen weiteren Wafers erfolgt, wobei ein Fehler aus dem Vergleich der gemessenen radialen Verteilung der Homogenitätsfunktion und des erlernten Empfindlichkeitsprofils bestimmt ist.

3. Verfahren nach Anspruch 1, **dadurch gekennzeichnet, dass** der Fehler durch das Unterschreiten des erlernten Empfindlichkeitsprofils durch die gemessene radialen Verteilung der Homogenitätsfunktion bestimmt ist und als solcher auf einer bildlichen Darstellung des mindestens einen weiteren Wafers markiert wird.

4. Verfahren nach Anspruch 1, **dadurch gekennzeichnet, dass** das erlernte Empfindlichkeitsprofil vom Abstand zum Mittelpunkt des Wafers abhängig ist.

5. Verfahren nach Anspruch 1, **dadurch gekennzeichnet, dass** das mehrere verschiedene Profilformen zum Bestimmen des erlernten Empfindlichkeitsprofil vom Benutzer ausgewählt werden können.

6. Verfahren nach Anspruch 5, **dadurch gekennzeichnet, dass** drei verschiedene Profilformen zum Bestimmen des erlernten Empfindlichkeitsprofil vom Benutzer ausgewählt werden können.

7. Verfahrenen nach einem der Ansprüche 1 bis 6, **dadurch gekennzeichnet, dass** eine erste Profilform unabhängig von der radialen Position auf dem Wafer ist.

8. Verfahrenen nach einem der Ansprüche 1 bis 6, **dadurch gekennzeichnet, dass** eine zweite Profilform einen ersten und einen zweiten Abschnitt aufweist, von denen mindestens einer in der Steigung verändert werden kann.

9. Verfahrenen nach einem der Ansprüche 1 bis 6, **dadurch gekennzeichnet, dass** eine dritte Profilform vorgesehen ist, die einen ersten, einen zweiten und einen dritten Abschnitt aufweist, von denen mindestens einer in der Steigung verändert werden kann.

10. Verfahrenen nach einem der vorherigen Ansprüche, **dadurch gekennzeichnet, dass** mindestens ein Parameter veränderbar ist, um das Empfindlichkeitsprofil an radiale Homogenitätsfunktion eines Wafers anzugleichen.

11. Verfahren nach Anspruch 10, **dadurch gekennzeichnet, dass** mindestens ein Parameter die radiale Position eines Übergangs zwischen zwei Abschnitten des Empfindlichkeitsprofils definiert, die sich in der Steigung unterscheiden.

12. Verfahren nach Anspruch 10, **dadurch gekennzeichnet, dass** ein Parameter ein Niveau des Empfindlichkeitsprofils definiert, wobei mindestens drei Niveaus des Empfindlichkeitsprofils einstellbar sind.

13. Verfahren nach Anspruch 12, **dadurch gekennzeichnet, dass** die Einstellung des Niveaus durch jeweils einem Slider verändert werden können.

14. Verfahren nach einem der Ansprüche 1 bis 13, **dadurch gekennzeichnet, dass** mehrere eingelernte Empfindlichkeitsprofile kombiniert werden.

15. Verfahren nach einem der Ansprüche 1 bis 13, **dadurch gekennzeichnet, dass** ein eingelerntes Empfindlichkeitsprofil jederzeit gegen ein neu eingelerntes Empfindlichkeitsprofil ersetzbar ist.

## Claims

1. A method for evaluating recorded images of wafers, **characterized by** the following steps:
- recording the image of at least one reference wafer,
- determining and representing the radial distribution of the measurement values from the reference wafer as a radial homogeneity function on a user interface, and
- altering a radially dependent sensitivity profile, taking account of the radial homogeneity function of the reference wafer, wherein at least one parameter of the sensitivity profile is varied, whereby a learned sensitivity profile is determined visually from the comparison with the radial homogeneity function.

2. The method according to claim 1, **characterized in that** the determination of errors on at least one further wafer takes place on the basis of the comparison of the learned radial sensitivity profile of the at least one reference wafer with the measured radial distribution of the homogeneity function of the at least one further wafer, wherein an error is determined from the comparison of the measured radial distribution of the homogeneity function with the learned sensitivity profile.

3. The method according to claim 1, **characterized in that** the error is determined through the undershooting of the learned sensitivity profile by the measured radial distribution of the homogeneity function and as such is marked on a pictorial representation of the at least one further wafer.

4. The method according to claim 1, **characterized in that** the learned sensitivity profile is dependent on the distance from the centre point of the wafer.

5. The method according to claim 1, **characterized in that** a plurality of different profile forms can be selected by the user to determine the learned sensitivity profile.

6. The method according to claim 5, **characterized in that** three different profile forms can be selected by the user to determine the learned sensitivity profile.

7. The method according to any one of the claims 1 to 6, **characterized in that** a first profile form is independent of the radial position on the wafer.

8. The method according to any one of the claims 1 to 6, **characterized in that** a second profile form has a first and a second section, and the slope of at least one of said sections can be altered.

9. The method according to any one of the claims 1 to 6, **characterized in that** a third profile form is provided which has a first, a second and a third section, and the slope of at least one of said sections can be altered.

10. The method according to at least one of the preceding claims, **characterized in that** at least one parameter can be altered in order to adjust the sensitivity profile to the radial homogeneity function of a wafer.

11. The method according to claim 10, **characterized in that** at least one parameter defines the radial position of a transition between two sections of the sensitivity profile, which differ in their slope.

12. The method according to claim 10, **characterized in that** one parameter defines a level of the sensitivity profile, wherein at least three levels of the sensitivity profile can be set.

13. The method according to claim 12, **characterized in that** the setting of the level can be altered by a slider in each case.

14. The method according to any one of the claims 1 to 13, **characterized in that** a plurality of learned sensitivity profiles are combined.

15. The method according to any one of the claims 1 to 13, **characterized in that** a learned sensitivity profile can be replaced at any time with a newly learned sensitivity profile.

## Revendications

1. Procédé pour l'évaluation d'images enregistrées de plaquettes **caractérisé par** les étapes suivantes :
- enregistrement de l'image d'au moins une plaquette de référence,
- détermination et représentation de la distribution radiale des valeurs de mesure de la plaquette de référence comme fonction d'homogénéité radiale sur une interface utilisateur, et
- modification d'un profil de sensibilité radialement dépendant en tenant compte de la fonction d'homogénéité radiale de la plaquette de référence, étant donné qu'au moins un paramètre du profil de sensibilité est varié, ce par quoi un profil de sensibilité appris est déterminé visuellement à partir de la comparaison avec la fonction d'homogénéité radiale.

2. Procédé selon la revendication 1, **caractérisé en ce que** la détermination d'erreurs se fait sur au moins une autre plaquette à l'aide de la comparaison du profil de sensibilité radial appris de la ou des plaquettes des référence avec la distribution radiale mesurée de la fonction d'homogénéité de l'autre ou des autres plaquettes, étant donné qu'une erreur est déterminée à partir de la comparaison de la distribution radiale mesurée de la fonction d'homogénéité avec le profil de sensibilité appris.

3. Procédé selon la revendication 1, **caractérisé en ce que** l'erreur se détermine par le sous-dépassement du profil de sensibilité appris par la distribution radiale mesurée de la fonction d'homogénéité et est identifiée comme telle sur une représentation imagée de l'autre ou des autres plaquettes.

4. Procédé selon la revendication 1, **caractérisé en ce que** le profil de sensibilité appris dépend de la distance au point central de la plaquette.

5. Procédé selon la revendication 1, **caractérisé en ce que** plusieurs formes de profils différentes peuvent être sélectionnées pour déterminer le profil de sensibilité appris de l'utilisateur.

6. Procédé selon la revendication 5, **caractérisé en ce que** trois formes de profils différentes peuvent être sélectionnées pour déterminer le profil de sensibilité appris de l'utilisateur.

7. Procédé selon l'une quelconque des revendications 1 à 6, **caractérisé en ce qu'**une première forme de profil est indépendante de la position radiale sur la plaquette.

8. Procédé selon l'une quelconque des revendications 1 à 6, **caractérisé en ce qu'**une deuxième forme de profil présente une première et une deuxième section dont l'une au moins peut être variée en pente.

9. Procédé selon l'une quelconque des revendications 1 à 6, **caractérisé en ce qu'**une troisième forme de profil présentant une première, une deuxième et une troisième section dont l'une au moins peut être variée en pente est prévue.

10. Procédé selon l'une quelconque des revendications précédentes, **caractérisé en ce qu'**au moins un paramètre est variable afin d'adapter le profil de sensibilité à la fonction d'homogénéité d'une plaquette.

11. Procédé selon la revendication 10, **caractérisé en ce que** au moins un paramètre définit la position radiale d'une transition entre deux sections du profil de sensibilité qui se distinguent en ce qui concerne la pente.

12. Procédé selon la revendication 10, **caractérisé en ce qu'**un paramètre définit un niveau de sensibilité, étant donné qu'au moins trois niveaux de sensibilité peuvent être réglés.

13. Procédé selon la revendication 12, **caractérisé en ce que** le réglage de chaque niveau peut être varié par un coulisseau correspondant.

14. Procédé selon l'une quelconque des revendications 1 à 13, **caractérisé en ce que** plusieurs profils de sensibilité appris peuvent être combinés.

15. Procédé selon l'une quelconque des revendications 1 à 13, **caractérisé en ce que** tout profil de sensibilité appris peut à tout moment être remplacé par un nouveau profil de sensibilité appris.
